# EUROPEAN PATENT SPECIFICATION

(11) **EP 3 543 443 B1**
(45) Date of publication and mention of the grant of the patent: **11.01.2023**
(21) Application number: 17871563.7
(22) Date of filing: 30.05.2017
(51) Int. Cl.: E05C 1/16

(54) **SYSTEM FOR LOCKING INTERIOR DOOR LATCHES**
SYSTEM ZUR VERRIEGELUNG VON INNENTÜRRIEGELN
SYSTÈME DE FERMETURE DE VERROU DE PORTE (BATTANT)

(30) Priority: 18.11.2016 KZ 20161072
(43) Date of publication of application: 25.09.2019
(73) Proprietor: Zlavdinov, Rustem Latipovich, Almaty 050035 (KZ)
(72) Inventor: Zlavdinov, Rustem Latipovich, Almaty 050035 (KZ)
(74) Representative: Jeck, Anton
(86) International application number: PCT/KZ2017/000015
(87) International publication number: WO 2018/093242

(56) References cited:
- AU-B2- 546 394
- GB-A- 2 203 478
- SU-A1- 1 557 307
- SU-A3- 1 836 532
- US-A- 2 008 668
- US-A- 2 207 143
- US-A- 2 207 143
- US-A- 5 171 049

## Description

The invention relates to locks, in which the sliding door latch is also used as a locking bar in accordance with claim 1.

A locking device known in this field is described in RU 2135720 C1 published on August 27, 1999 (E05C1/16). All parts of this locking device are contained within a common metal case, including door handles, with the exception of a specially designed spring-bolt. To install this device, two special crosswise openings in the door panel are required, one of which is located perpendicular to the front side of the door and has a very large diameter barely covered by the handle rosettes.

A disadvantage of this device is that if the appearance of the lock has to be changed, the whole door will have to be replaced, since the mounting seats do not allow for installing a lock of a different system.

Another known cut-in door latch is disclosed in RU 1836532 A3 published on August 23, 1993 (Bulletin 31, E05B55/14). The proposed design utilizes a principle, according to which the latch is locked by the rotating stops, located inside the hollow cases of the interior knobs, which restrict the movement of the sliding tab, and thus, prevent pushing the buttons, which open the door. This device also requires a special key for unlocking the door from outside in case of an emergency. The mounting bores intended such latch can also be used for installing conventional, commonly used door latches and knobs/handles in combination with rosettes or plates.

AU 546 394 teachers a locking mechanism for the door of the security enclosure which includes a boltwork, one or more locks for selectively locking the bolt work in its thrown condition, a manipulable control member accessible on the outside of the door, a mechanical transmission for coupling said control member to the boltwork for throwing and withdrawing the same.

GB 2 203 478 A discloses a door latch assembly comprising a latch bolt retractable by an inner or outer handle and a bell struck by strikers upon rotation of either handle. The assembly comprises a mechanism. In a locked state the handles are disengaged from the latch bolt so that in the locked state to handles may be turned without moving the bolt, but the bell is still struck.

This invention still has the same common disadvantages, such as complexity of fabrication and installation of the lock, excessive metal consumption, as well as lack of flexibility and softness of operation. Such products do not allow for replacing the knobs or a latch independently of each other. The need to store and use a special key for emergency unlocking is also a disadvantage. However, the main disadvantage is a short service life of the contacting parts due to rigid fixation of the knobs by the rotating stops, which fail as a result of repeatedly applied loads, since a person, who is trying to open the door, instinctively transfers excessive force onto all parts of the lock.

The closest to the proposed invention is the cut-in door lock with additional fixation as disclosed in the specification to SU 1557307 A1 published on April 15, 1990 (Bulletin 14, E05B55/14). The locking bar of this lock is embodied in the form of a generally accepted spring-loaded sliding latch controlled by a standard square rod. The main difference of this lock consists in a pair of door handles mounted on rosettes, wherein the interior handle is configured to rotate in the direction opposite to door opening upon pressing a supplemental axial button, and to be fixated in the vertical position by a tongue between the rosette stops. This fixation also limits the rotation of the square rod, thereby blocking the exterior handle, which also blocks the latch. This lock provides the possibility to replace door handles and latch independently of each other, while the mounting bores can be reused.

A disadvantage is that once locked, this lock (when used in an interior door) cannot be opened from outside without destroying it. Besides, abnormal appearance of the handle in the locked position makes the product look like it is broken. However, rigid fixation of the exterior handle remains to be the main disadvantage. When the lock is in the "locked" position, a person, experiencing an obstacle in the form of a handle that cannot be turned, tries to instinctively overcome such obstacle, which causes an intensive wear of all assemblies and mechanisms of the lock.

The technical objective is to create a simple, universal, and reliable system for using latches controlled by a square rod as locks which do not require the use of additional concurrently installed mechanisms, wherein said system would have polymer material properties (elasticity, wear resistance, low friction coefficient) and would ensure optimization of the production costs as well as expenses for installation prior to use. The system would offer high performance characteristics, such as quiet and soft operation, durability, and compatibility with other types of cut-in spring-loaded or magnetic door latches.

The technical objective of the present invention is provision of is provision of a system, which can easily lock door (leaf) latches controlled by a square rod, which allows to fully achieve the above objective.

This task is solved according to the present invention by a system for locking latches according to claim 1.

This technical result is achieved by the fact that the mechanisms of the invented system are contained inside a tetrahedral core-rod representing a main case, which has a round flat spot along the edges in the place of interaction with door latch, and a round stop from the side of the interior door handle. The flat spot enables free turning of the square core-rod inside the latch, which determines the condition of the lock in the "locked" position. The "unlocked" position is enabled by at least one pair of balls interacting with the latch, which are pushed from inside out in the different directions along the diagonal of the square rod within the limits of its external flat spot while being tightly pressed from underneath by the axial spring-loaded pin having a varying cross-section, which passes along the axis of the square core-rod from the side of the interior door handle of the lock. Also, mounted on this end of the tetrahedral rod is a mechanism, which controls the displacement of the pin and fixates the balls pushed out into the required position.

In addition, this system, which easily locks door (leaf) latches, is provided with a pair of door handles. The interior handle has a spring-loaded button installed in the part coaxial with the square core-rod. When pressed, this button enables the movement of the supporting pin through the fixating mechanism located at the end of the tetrahedral rod for pushing out at least one pair of balls interacting with the latch for opening it when the door handles are turned. The exterior handle may have an opening measuring 1-1.5 mm in diameter, which is coaxial with the square rod and is intended for opening the door in case of an emergency by pressing it with any thin needle, such as an unbent end of a paper clip.

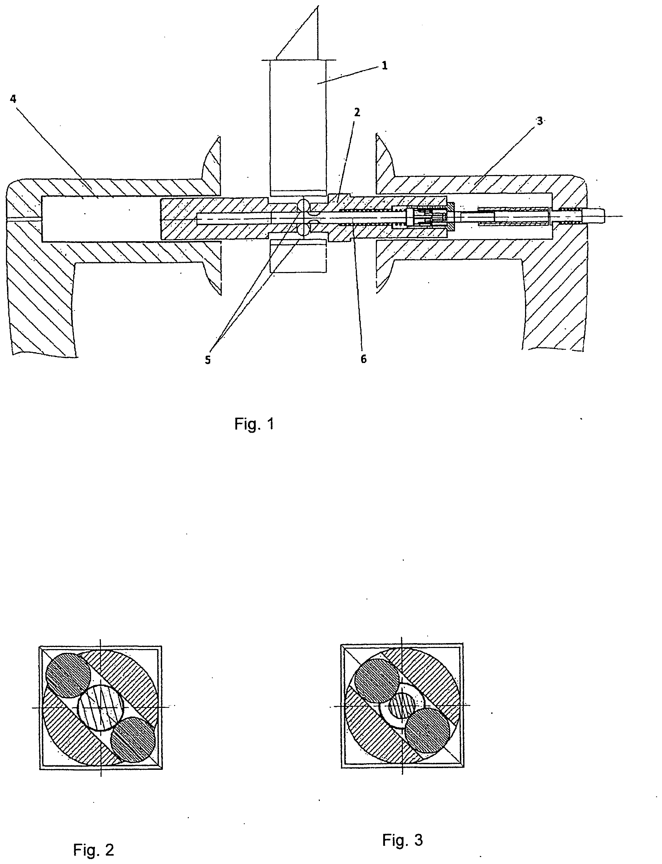

The substance of the invention is explained by the drawings, where in Fig. 1, (1) is a door latch; (2) is a control square core-rod; (3) is an interior door handle with the button; (4) is an exterior door handle; (5) are check balls; and (6) is a supporting pin interacting with the button.

The system for locking door (leaf) latches, which is a combination of interacting mechanisms, has two operating positions: Fig. 2 illustrates the "unlocked" position, in which by turning the control core-rod it is possible to move the bar of the latch; and Fig. 3 illustrates the "locked" position, when the control rod does not interact with the latch.

The case of the mechanism, spring-loaded pin and other elements of the invented system for locking door (leaf) latches can be made of either a metal or plastic material, such as polycaprolactone or polyamide, which significantly simplifies the production process. The door handles would have to be slightly modified by adding holes, which practically does not affect their production.

The invented system for locking door (leaf) latches is compatible with the conventional spring-loaded or magnetic latches of the interior doors and allows controlling them, and thus, turning them into safe, full-fledged locks of the interior doors used in bedrooms, bathrooms, etc., which can be easily locked and unlocked by one touch of a finger. The system also provides a possibility of opening the door from outside in case of an emergency.

### Reference list

- 1: Door latch
- 2: Square controlling rod
- 3: Interior handle with button
- 4: Exterior handle
- 5: 5 Check bearings
- 6: Loaded pin for interaction with button

## Claims

1. A system for locking door (leaf) latches (1) comprising
a control core-rod (2) and two handles (3, 4), wherein said control core-rod (2) is the case of an easily blocking control mechanism and has a cylindrical section in the place of contact with a latch (1), wherein the mechanism displaces a bar of the latch (1) by transferring force from turning the handles using balls (5), which are pushed out radially along the diagonal of a square of the section of the control core-rod (2) within the cylindrical section, while being tightly pressed from underneath by the body of a pin (6), wherein the pin (6) has a varying cross section for pushing said balls (5) in and out, and the system also features a button located inside the interior handle (3) along the axis of the control core-rod (2), which transfers motion to the pin (6), **characterized in that**
the control rod (2) is square, and the pin (6) and button are spring loaded, wherein the required displacement of the pin (6) is controlled by a fixating mechanism, and the spring-loaded button transfers translational reciprocating motion to the spring-loaded pin (6) through the fixating mechanism, while the exterior handle (4) has a narrow opening along the axis of the control square core-rod (2) for unlocking the mechanism and opening the door leaf from outside in case of an emergency by simply pressing with a thin needle.

## Patentansprüche

1. System zum Verriegeln von Türschlössern (1) mit
eine Steuerkernstange (2) und zwei Griffe (3, 4), wobei die Steuerkernstange (2) das Gehäuse eines leicht blockierbaren Steuermechanismus ist und einen zylindrischen Abschnitt an der Stelle des Kontakts mit einem Riegel (1) aufweist, wobei der Mechanismus eine Stange des Riegels (1) durch Übertragung von Kraft aus einer Drehung der Griffe unter Verwendung von Kugeln (5) verschiebt, die radial entlang der Diagonale eines Quadrats des Querschnitts des Steuerkernstabs (2) innerhalb des zylindrischen Abschnitts herausgedrückt werden, während sie von unten durch den Körper eines federbelasteten Stifts (6) fest gedrückt werden, wobei der Stift (6) einen variierenden Querschnitt zum Hinein- und Herausdrücken der Kugeln (5) aufweist, ,
und das System auch einen Knopf aufweist, der innerhalb des Innengriffs (3) entlang der Achse der Steuerstange (2) angeordnet ist, der eine Bewegung auf den Stift (6) überträgt, **dadurch gekennzeichnet, dass** die Steuerstange (2) quadratisch ist und der Stift (6) und der Knopf federbelastet sind, wobei die erforderliche Verschiebung des Stifts (6) durch einen Fixiermechanismus gesteuert wird, und der federbelastete Knopf über den Fixiermechanismus eine Hin- und Herbewegung auf den federbelasteten Stift (6) überträgt, während der äußere Griff (4) eine schmale Öffnung entlang der Achse der quadratischen Steuerstange (2) aufweist, um den Mechanismus zu entriegeln und den Türflügel im Notfall durch einfaches Drücken mit einer dünnen Nadel von außen zu öffnen.

## Revendications

1. Système pour le verrouillage de serrures de porte (1) avec une tige de noyau de commande (2) et deux poignées (3,4) où la tige de noyau de commande (2) consiste en le boîtier d'un mécanisme de commande légèrement blocable présentant une section cylindrique à la place du contact avec un verrou (1) où le mécanisme déplace une tige du verrou (1) par le biais de la transmission de la puissance de la rotation des poignées par l'utilisation de boules (5) qui sont essorées radialement tout au long du diagonale d'un carré de la section transversale de la barre de noyau du commande (2) à l'intérieur de la section cylindrique, tandis qu'elles sont étroitement pressées par le bas par le biais du corps d'un stylo chargé par ressort (6) où le stylo (6) présente une coupe transversale variant pour l'introduction et l'expulsion des boules (5);
Et le système présente aussi un bouton qui est disposé à l'intérieur de la poignée intérieure (3) tout au long de l'axe de la tige de commande (2) qui transmet un mouvement sur le stylo (6) est caractérisé de sorte que la tige de commande (2) est quadratique et le stylo (6) ainsi que le bouton sont chargés par ressort où le déplacement nécessaire du stylo (6) est commandé par un mécanisme de fixation et le bouton chargé par ressort transmet via le mécanisme de fixation un mouvement alternatif sur le stylo chargé par ressort (6), tandis que la poignée extérieure (4) présente une ouverture étroite tout au long de l'axe de la tige de commande quadratique (2) pour déverrouiller le mécanisme et ouvrir de l'extérieur d'une simple pression avec une fine aiguille le battant de porte en cas d'urgence.
